(19)

Europäisches
Patentamt
European
Patent Office
Office européen
des brevets

(11) **EP 3 530 712 A1**

(12) **EUROPEAN PATENT APPLICATION**

(43) Date of publication:
**28.08.2019 Bulletin 2019/35**

(51) Int Cl.:
**C09K 11/02** *(2006.01)*   **H05B 33/14** *(2006.01)*

(21) Application number: **18158199.2**

(22) Date of filing: **22.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **SABIC Global Technologies B.V.**
**4612 PX Bergen op Zoom (NL)**

(72) Inventors:
 • **LEE, Changmin**
  **4216 PX Bergen op Zoom (NL)**
 • **KANG, Hyunjin**
  **4216  Bergen op Zoom (NL)**
 • **KIM, Namhun**
  **4216 PX Bergen op Zoom (NL)**
 • **KIM, Daekyung**
  **4216 PX Bergen op Zoom (NL)**
 • **CHAE, Heeyeop**
  **06708 Seoul (KR)**
 • **KIM, Seongwon**
  **135 Seoul (KR)**
 • **LEE, Jongwoo**
  **Seoul (KR)**
 • **HYUN, Soonyoung**
  **Gyeonggi-do (KR)**
 • **SHIN, Kahee**
  **02792 Seoul (KR)**
 • **LEE, Sunyoung**
  **Gyeonggi-do (KR)**
 • **LIM, Jeongmin**
  **Gyeonggi-do (KR)**
 • **LEE, Chunim**
  **Gyeonggi-do (KR)**

(74) Representative: **Elzaburu S.L.P.**
**Miguel Angel 21, 2nd floor**
**28010 Madrid (ES)**

(54)   **PHASE SEPARATED QUANTUM DOT LAYER**

(57)   A film for light emitting devices is prepared by forming a quantum dot layer. The quantum dot layer may be formed by combining forming a combination of a first polymer matrix and a second polymer matrix. The first polymer matrix may comprise a plurality of first quantum dots disposed in a first polymer. The second polymer matrix may comprise a plurality of second quantum dots disposed in a second polymer.

**EP 3 530 712 A1**

**Description**

Technical Field

The disclosure generally relates to a quantum dot film, and more particularly to methods and structures utilizing a quantum dot film.

Background

Quantum dots (QDs) represent an area of expanding technological interest as a promising class of emissive materials. These materials may be characterized as semiconductor particles with dimensions on the order of 2 nanometers (nm) to about 100 nm and may often be referred to as nanocrystals. QDs provide size-tunable electronic, optical and chemical properties. QDs may display comparatively strong emission in the visible region of the electromagnetic spectrum while the wavelength of light absorbed and emitted by the QD is a function of the size of the QD. The unique optical properties of QDs make them desirable for a number of diverse commercial areas including solar cells, chemical catalysis, biological imaging and labeling, and light-emitting diodes among many others.

Various teachings are known in the art that relate to quantum dot films, polymers, or other features related to the disclosure. For example, "Energy transfer in aqueous solutions of oppositely charged CdSe/ZnS core/shell quantum dots and in quantum dot-nanogold assemblies," (2004) by Wargnier discloses that the nanoscale assemblies of water-solubilized, oppositely charged CdSe/ZnS core/shell quantum dots and of quantum dots and nanogold particles make it possible to develop FRET-based sensors with a donor quenching efficiency close to 100%.

"Forster Resonance Energy Transfer Investigations Using Quantum-Dot Fluorophores," (2006) by Aaron discloses Fçrster resonance energy transfer (FRET) is very sensitive to nanometer-scale changes in donor-acceptor separation distance and their relative dipole orientations, and discusses some of the basic aspects of FRET applied to QDs as both donors and acceptors, and highlight some of the advantages offered (and limitations encountered) by QDs as energy donors and acceptors compared to conventional dyes.

"Efficient Heterotransfer between Visible Quantum Dots," (2017) by Yin discloses fabrication of green-red (GR) and blue-red (BR) bilayer stacked quantum dots (QDs) using electrospray deposition.

WO2015022526A1 discloses multi-phase polymer films containing quantum dots (QDs).

"Phase Behavior of Blends of Polycarbonate with Partially Miscible Polymers," (1990) by Kim discloses investigation of phase behavior of blends of bisphenol A polycarbonate (PC) with polystyrene (PS), poly(styrene-co-acrylonitrile) (SAN), poly(acrylonitrile-butadiene-styrene) (ABS), poly(methyl methacrylate) (PMMA), poly(ethylene terephthalate) (PET), and poly(butylene terephthalate) (PBT).

These teachings in the art have shortcomings in function, cost, and/or other aspects. For example, certain optical constructions or devices making use of quantum dots may be hindered and result in reduced conversion efficiency and color gamut. Thus, there is a need for improved quantum dot films.

Summary

A film (e.g. or composition) for light emitting devices is disclosed. According to one example, the film comprising a plurality of first quantum dots disposed in a first polymer, wherein the plurality of first quantum dots emit first secondary light upon excitation by light; and a plurality of second quantum dots disposed in a second polymer, wherein the plurality of second quantum dots emit second secondary light upon excitation by light, wherein the first polymer is combined with the second polymer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the first polymer is partially miscible or immiscible relative to the second polymer.

In further aspects, the present disclosure relates to a method comprising forming a first polymer matrix comprising a plurality of first quantum dots disposed in a first polymer, wherein the plurality of first quantum dots emit first secondary light upon excitation by light; forming a second polymer matrix comprising a plurality of second quantum dots disposed in a second polymer, wherein the second polymer is partially miscible with the first polymer, wherein the plurality of second quantum dots emit second secondary light upon excitation by light; forming a combination of the first polymer matrix and the second polymer matrix, wherein the first polymer matrix is combined with the second polymer matrix such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the first polymer is partially miscible or immiscible relative to the second polymer; and forming a quantum dot layer comprising the combination of the first polymer matrix and the second polymer matrix.

The present disclosure relates to a film comprising a plurality of first quantum dots disposed in a first polymer, wherein the plurality of first quantum dots emit first secondary light upon excitation by light. The film may comprise a plurality of second quantum dots disposed in a second polymer, wherein the plurality of second quantum dots emit second secondary light upon excitation by light, wherein the first polymer is combined with the second polymer and a compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a partial miscibility of the first polymer relative to the second polymer and the compatibilizer, wherein the first polymer is immiscible relative to the second polymer without the compatibilizer.

The present disclosure relates to method comprising forming a first polymer matrix comprising a plurality of first quantum dots disposed in a first polymer, wherein the plurality of first quantum dots emit first secondary light upon excitation by light. The method may comprise forming a second polymer matrix comprising a plurality of second quantum dots disposed in a second polymer, wherein the second polymer is partially miscible with the first polymer, wherein the plurality of second quantum dots emit second secondary light upon excitation by light. The method may comprise forming a combination of the first polymer matrix and the second polymer matrix and a compatibilizer, wherein the first polymer matrix is combined with the second polymer matrix and the compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the first polymer is immiscible relative to the second polymer without the compatibilizer (e.g., the miscibility of the first polymer relative to the second polymer and the compatibilizer is greater than 0% and less than 100%). The method may comprise forming a quantum dot layer comprising the combination

The present disclosure also relates to an article comprising any of the disclosed films.

In some aspects, the disclosure relates to a device comprising a light source and a quantum dot layer comprising any of the disclosed films.

Brief Description of the Drawings

The above-mentioned and other features and advantages of this disclosure, and the manner of attaining them, will become apparent and be better understood by reference to the following description of one aspect of the disclosure in conjunction with the accompanying drawings, wherein:

FIG. 1A is a diagram illustrating example light emission and absorption.
FIG. 1B is a diagram illustrating another example of light emission.
FIG. 2 is a diagram illustrating an example quantum dot layer.
FIG. 3A is a schematic representation of a cross-section of a film according to an aspect of the present disclosure.
FIG. 3B is a three-dimensional representation of a film according to an aspect of the present disclosure.
FIG. 4A is a diagram illustrating an example backlight structure.
FIG. 4B is a diagram illustrating an example optical device.
FIG. 5A is a diagram illustrating an example process for forming a film.
FIG. 5B is a diagram illustrating another example process for forming a film.
FIG. 6A is a diagram illustrating another example process for forming a film.
FIG. 6B is a diagram illustrating another example process for forming a film.
FIG. 7 is a graph illustrating intensity and wavelength for different films.
FIG. 8A is a graph illustrating a glass transition temperatures of separate polymers.
FIG. 8B is a graph illustrating another glass transition temperature of a miscible polymer blend.
FIG. 8C is a graph illustrating another transition temperature of an immiscible polymer blend.

Detailed Description

As luminescent nanomaterials, QDs provide size-controlled tunable emission wavelengths and feature almost continuous above-band-edge absorption and a narrow emission spectrum at near-band-edge energies. The optical spectra of QDs depend directly on their size. Thus, their emission color may be continuously tuned from the infrared (IR) to ultraviolet (UV) by altering QD size and/or composition. These unique properties of QDs have been explored for use in various devices such as LEDs, lasers, solar cells, photo detectors, and liquid crystal displays (LCDs). LCDs are non-emissive displays having a separate backlight unit and red, green, and blue color filters from which pixels display a color image on a screen. These red, green, and blue color filters respectively separate white light emitted from the backlight unit into red, green, and blue lights. Each of the color filters transmits only light of a narrow wavelength band and absorbs the rest of the visible spectrum, resulting in significant optical loss. A high luminance backlight unit is needed to produce an image with sufficient luminance. The range of colors that can be displayed by an LCD device may be referred to as color gamut and may be determined by the combined spectra of the backlight unit and the color filters of the LCD panel. In conventional QD films, randomly distributed, blends of quantum dots at varying sizes, which correspond to different emission wavelengths, may be suspended or dispersed throughout one or more layers of a polymer film. When used in conjunction with a blue LED light source limitations arise. Random distribution of dots may result in some QDs being completely or substantially blocked by other quantum dots in the optical path from the excitation light source (e.g., the blue LED) such that the QDs are not equally exposed to the light source for excitation. Moreover, because of the mixture of varying sizes, green fluorescence from the smaller QDs may be reabsorbed by larger QDs and converted to red fluorescence. This occurrence may result in reduced conversion efficiency of the QDs because the quantum yield (here, for example, photons emitted/photons absorbed) would be less than one. Uncontrolled fluorescence light may vary the light intensity ratio or profiles of blue, red, and green in local areas.

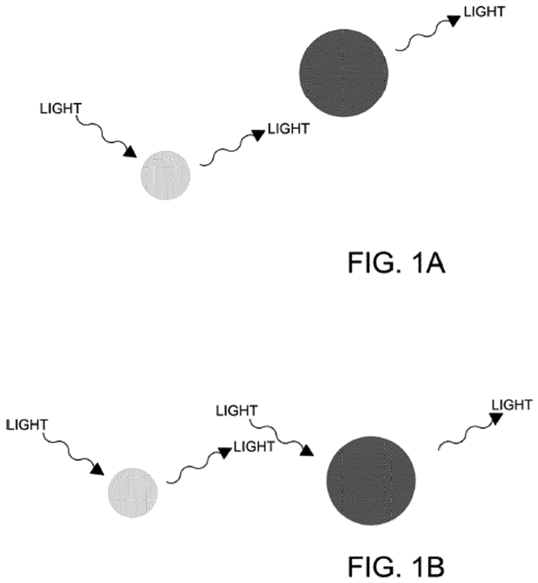

When two different size QDs are mixed in one layer, shorter wavelength emission from smaller QDs can be reabsorbed to larger QDs, as shown in FIG. 1A. This reabsorption of green light to red QD causes energy loss during reconverting process. The present disclosure decreases or prevents green light emitted by smaller QDs from absorbing to larger QDs, thereby increasing quantum efficiency as shown in FIG. 1B.

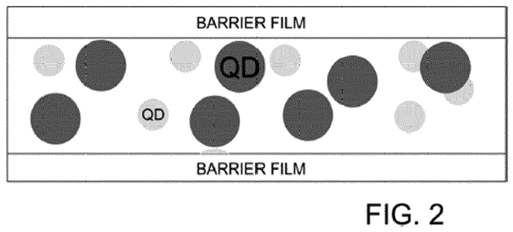

To prevent light reabsorption of shorter wavelength by smaller QDs to larger QDs, a layer structure may be used. In a layer structure, a blue light source is converted to red light through a first red QD layer, then blue and red light transmitted through first layer is converted to green light through a second green QD layer. Red light converted through the first layer may not reabsorb to the smaller green QD thus quantum efficiency can be highly maintained. However the fabrication of multiple QD layers is a costly and complicated process. FIG. 2 shows a simple one layer QD film that may be used instead of complicated multi-layer structure. The one layer structure may lose some energy due to reabsorption by larger QDs of energy emitted from smaller QDs. As described further herein, the present disclosure describes a process for making more efficient one layer QD films.

In various aspects of the present disclosure, quantum dots of different sizes may be disposed in a single layer. Larger quantum does may disposed in a first polymer and smaller quantum dots may be disposed in a second polymer. The first polymer and the second polymer may be partially miscible or immiscible with respect to each other. The first polymer and the second polymer may be mixed together, resulting in a single layer having phase separated regions in which the larger quantum dots are separated from the smaller quantum dots. These phase separated regions decrease and/or prevent the larger quantum dots from absorbing light emitted from the smaller quantum dots, thereby resulting in a more efficient film.

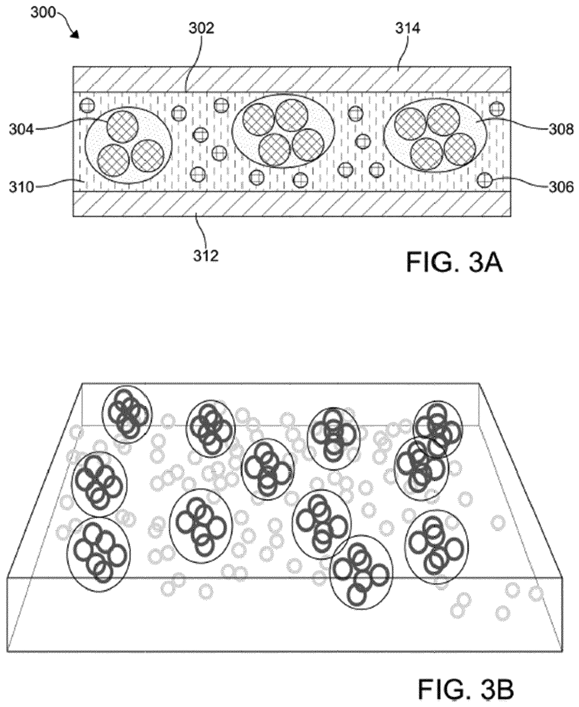

FIG. 3A shows a cross-sectional view of an example film 300 (e.g., or composition). FIG. 3B shows a three dimensional view of the example film 300. The film 300 may comprise a quantum dot layer 302. The quantum dot layer 302 of the film 300 may have a particular thickness. The thickness of quantum dot layer 302 may range from 10 micrometers (micron, $\mu$m) to 1000 $\mu$m. For example, the quantum dot layer 302 may have a thickness of about 100 $\mu$m. It should be understood that though the term film is used for purposes of illustration, the described films may also be or comprise a composition comprising at least a portion of the features of the described films.

The quantum dot layer 302 may comprise a plurality of first quantum dots 304. The quantum dot layer 302 may comprise a plurality of second quantum dots 306. The plurality of first quantum dots 304 may emit light in a first wavelength range upon excitation. The plurality of first quantum dots 304 may emit first secondary light upon excitation by light. The plurality of first quantum dots 304 may comprise quantum dots sized from about 3 nanometers (nm) to about 11 nm. The plurality of first quantum dots 304 may comprise red phosphor with a peak emission wavelength between about 600 nm to about 750 nm. The plurality of second quantum dots 306 may emit light in a second wavelength range upon excitation. The plurality of second quantum dots 306 may emit second secondary light upon excitation by light. The plurality of second quantum dots 306 may comprise quantum dots sized from about 1 nm to about 8 nm. The plurality of second quantum dots 306 may comprise green phosphor with a peak emission wavelength between about 490 nm to about 580 nm.

The plurality of first quantum dots 304 may comprise a core shell structure, such as a nanocrystal shell structure. The plurality of second quantum dots 306 may comprise a core-shell structure, such as a nanocrystal shell structure. The plurality of first quantum dots 304 may comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof. The plurality of second quantum dots 306 may comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

The plurality of first quantum dots 304 may be disposed in a first polymer 308 (e.g., or first polymer matrix). The plurality of second quantum dots 306 may disposed in a second polymer 310 (e.g., or second polymer matrix). The first polymer 308 may be combined with the second polymer 310 such that at least a portion of the plurality of first quantum dots 304 are caused to be dispersed with at least a portion of the plurality of second quantum dots 306. A dispersion of the plurality of first quantum dots 304 and the plurality of second quantum dots 306 relative to each other may be dependent on a miscibility of the first polymer 308 relative to the second polymer 310. The first polymer 308 may be partially miscible or immiscible relative to the second polymer 310. The partial miscibility or the immiscibility of the first polymer 308 relative to the second polymer 310 may cause phase separation between portions of the plurality of first quantum dots 304 and portions of the plurality of second quantum dots 306.

The miscibility of the first polymer 308 relative to the second polymer 319 may be greater than 0% and less than 100% (e.g., or not greater than 100%). A solubility parameter may be indicative of the miscibility. Two polymers that have solubility parameters within a threshold similarity (e.g., or threshold range, threshold difference) may be partially miscible. For example, the first polymer 308 may have a first solubility parameter value. The second polymer 310 may have a second solubility parameter value. The first solubility parameter value may be within a threshold similarity (e.g., or threshold range, threshold difference) of the second solubility parameter value. Example solubility parameters are shown in the Table 1, as shown below:

Table 1

| Polymers | $\delta/10^3$ $J^{1/2}m^{-3/2}$ |
|---|---|
| Polyethylene | 16.4 |
| Polystyrene | 18.5 |
| Polymethylmethacrylate | 19.0 |
| Polypropylene | 17 |
| Poly(vinyl chloride) | 20.0 |
| Polybutadiene | 14.6-17.6 |
| Polychloroprene | 15.2-19.2 |
| Polycrylonitrile | 25.3-31.5 |
| Poly(vinyl acetate) | 18.0-19.1 |
| Polyisobutylene | 14.5-16.5 |
| Poly(vinyl alcohol) | 25.8 |
| Nylon66 | 27.8 |

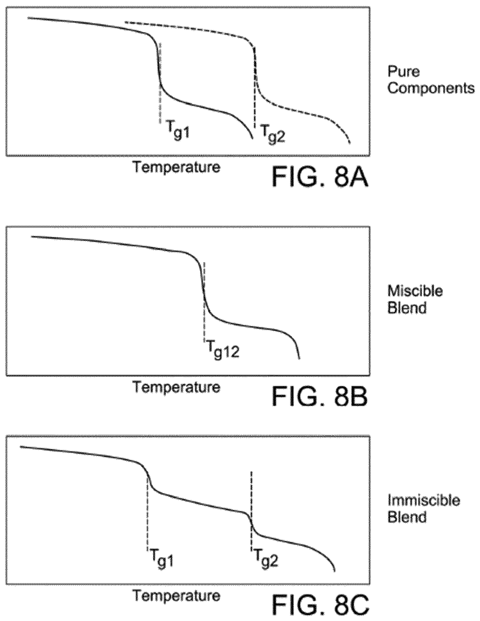

As another example, a glass transition temperature may be indicative of the miscibility. The glass transition temperature may comprise a temperature and/or temperature range at which a polymer changes from a rigid state to a pliable state. The first polymer 308 may have a first glass transition temperature. The second polymer 310 may have a second glass transition temperature. If the first polymer 308 is partially miscible with the second polymer 310, a combination of the first polymer 308 and the second polymer 310 may have a one or multiple glass transition temperatures. For example, if the first polymer 308 is partially miscible with the second polymer 310, then combination of the first polymer 308 and the second polymer 310 may have two phases with a mingled interface. If the first polymer 308 is partially miscible with the second polymer 310, then combination of the first polymer 308 and the second polymer 310 may have two separate glass transition temperatures. A combination of the first polymer 308 and the second polymer 310 may have multiple glass transition temperatures, if the first polymer 308 is immiscible with the second polymer 310. FIG. 8A illustrates the glass transition temperature of the first polymer 308 and the second polymer 310 when separate. As shown in FIG. 8B, if the first polymer 308 and the second polymer 310 are miscible, then the combination of the first polymer 308 and the second polymer 310 have a single glass transition temperature. As shown in FIG. 8C, if the first polymer 308 and the second polymer 310 are immiscible, then the combination of the first polymer 308 and the second polymer 310 may have multiple glass transition temperatures.

The first polymer 308 and the second polymer 310 may be combined with a compatibilizer. The first polymer 308 and the second polymer 310 may be immiscible without the compatibilizer. The first polymer 308, the second polymer 310, and the compatibilizer may be partially miscible. For example, combining the compatibilizer with the first polymer 308 and the second polymer 310 may cause the first polymer 308 and the second polymer 310 to be partially miscible. Combining the compatibilizer with the first polymer 308 and the second polymer 310 may cause a change in a miscibility and/or immiscibility of the first polymer 308 relative to the second polymer 310. The compatibilizer may comprise a copolymer, such as a block copolymer. The copolymer (e.g., block copolymer) may comprise the first polymer 308 (e.g.,

a unit or subunit of the first polymer 308). The copolymer (e.g., block copolymer) may comprise the second polymer 310 (e.g., a unit or subunit of the second polymer 310). As an illustration, if the first polymer 308 comprises polymethylmethacrylate (PMMA) and the second polymer 310 comprises polycarbonate (PC), then the copolymer may comprise a PMMA-PC block copolymer. As another illustration, if the first polymer 308 comprises Polystyrene (PS) and the second polymer 310 comprises PC, then the copolymer may comprise a PMMA-PC block copolymer. The following are example polymer combinations that may be combined with a compatibilizer to cause partial miscibility: polycarbonate (PC) and polyethylene terephthalate (PET), Polyethylene (PE) and Polystyrene (PS), Polycarbonate (PC) and Polyethylene (PE), Polycarbonate(PC) and Polypropylene(PP), Polypropylene (PP) and Polyvinylchloride (PVC), Polyethylene (PE) and Polyvinylidene fluoride (PVdF), Polymethylmethacrylate (PMMA) and Polystyrene(PS), Polycarbonate (PC) and Polystyrene(PS), Polycarbonate(PC) and Polymethylmethacrylate(PMMA), a combination thereof and/or the like.

The first polymer 308 may comprise a commodity resin, an engineering resin, a specialty resin, or a combination thereof. The first polymer 308 may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof. The second polymer 310 may comprise a commodity resin, an engineering resin, a specialty resin, or a combination thereof. The second polymer 310 may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

The following combinations are examples of partially miscible or immiscible combinations of polymers: polycarbonate and polymethylmethacrylate, polystyrene and polybutadiene, polyethylene terephthalate and polyvinylalcohol, polystyrene and polyethylene, polypropylene and polyamide, and/or the like.

The following combinations are examples of miscible combinations of polymers which may not be able to achieve phase separation in a single layer: polyphenylene oxide (PPO) and polystyrene (PS), polyethylene terephthalate (PET) and polybutylene terephthalate (PBT), poly(methyl methacrylate) (PMMA) and polyvinylidene fluoride (PVDF), Polypropylene (PP) and ethylene propylene diene monomer (EPDM), polycarbonate (PC) and acrylonitrile butadiene styrene (ABS).

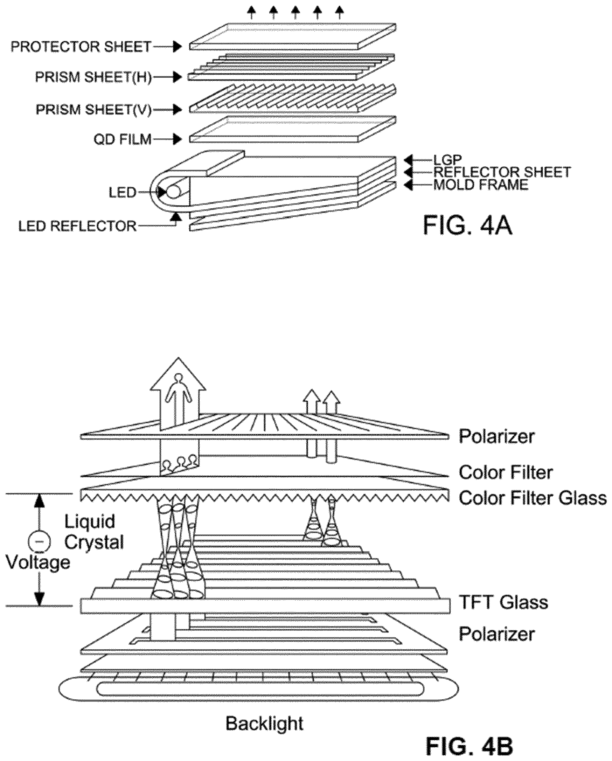

The quantum dot layer 302 may be disposed adjacent to a light source (e.g., as shown in FIG. 4A). The light source may comprise a blue light emitting source. For example, the blue light source may emit light in a range from 440 nm to 460 nm. The blue light source may have a Full Width, Half Max (FWHM) of less than 25 nm. The film may be a part of an optical device comprising an LCD panel having a native color gamut in a range from 35% to 45% NTSC, and one or more QD layers (as described herein) positioned or optically between the blue light source and the LCD panel. The optical construction may achieve a color gamut of at least 50% NTSC in some aspects.

In further examples, the composition of the first polymer and/or the second polymer may also be tailored to provide improved compatibility between the polymer and the surface chemistry of the plurality of first quantum dots and/or the plurality of second quantum dots. Accordingly, layers of the film may comprise a polymer (e.g., polymer matrix), a plurality of particular quantum dots, and in some aspects one or more compatibilizing additives. These additives may make the polymer more compatible with the QD. In further examples, the first polymer may be selected to be compatible to a ligand encapsulating the plurality of first quantum dots and the second polymer matrix may be selected to be compatible to a ligand encapsulating the plurality of second quantum dots. In another aspect, the ligand encapsulating the plurality of first quantum dots may be compatible (e.g., or may be selected to be compatible) with the first polymer. The ligand encapsulating the plurality of second quantum dots may be compatible (e.g., or may be selected to be compatible) with the second polymer.

The quantum dot layers described herein may have any useful amount of quantum dots. In many embodiments the quantum dot layer can have from about 0.001 wt% to about 10 wt% quantum dots or from about 0.05 to about 5 wt. % quantum dots. It is understood that various intervening endpoints in the proposed size ranges may be used. However, other loadings of quantum dots may be used.

The quantum dot layer 302 may comprise scattering beads or particles. Scattering beads may change the light path and redirect it to quantum dots that may be obstructed in the optical path. Generally, scattering beads do not contribute the light absorption and fluorescence emission. Scattering beads, especially placed in the layer furthest away from the LED Light source, may help to improve the uniformity of the transmitted blue light or the emitted red and green light. The inclusion of scattering particles may result in a longer optical path length and/or improved quantum dot absorption and efficiency in some aspects. In certain aspects the particle size is in a range from about 50 nm to about 10 micrometers, or in particular aspects from about 100 nm to about 6 micrometers. It is understood that various intervening endpoints in the proposed size ranges may be used. The quantum dot layer 302 may further include fillers such as fumed silica or yet other additives in some aspects.

As provided herein, the film 300 may comprise one or more barrier layers configured to enclose one or more of the first or second quantum dot layers, or additional quantum dot layers. The one or more barrier layers may be disposed adjacent a quantum dot layer to protect the quantum dot layer from oxygen and moisture. The one or more barrier layers may comprise a first barrier layer 312. The first barrier layer 312 may be disposed below the quantum dot layer 302. The one or more barrier layers may comprise a second barrier layer 314. The second barrier layer 314 may be disposed above the quantum dot layer 302. The one or more barrier layers may comprise any useful material that can protect the quantum dots from environmental conditions such as oxygen and moisture. Suitable barrier films include polymers, glass or dielectric materials, for example. Suitable barrier film materials include, but are not limited to, polymers such as polyethylene terephthalate (PET); oxides such as silicon oxide, titanium oxide, or aluminum oxide (e.g., $SiO_2$, $Si_2O_3$, $TiO_2$, or $Al_2O_3$); and suitable combinations thereof. The one or more barrier layers may include at least two layers of different materials or compositions, such that the multi-layered barrier eliminates or reduces pinhole defect alignment in the barrier layer, providing an effective barrier to oxygen and moisture penetration into the quantum dot layers.

In addition, the material included in the one or more barrier layers may include organic and inorganic hybrid materials. Optionally, the one or more barrier layers may comprise a functional layer. For example, the functional layer may be or include a diffuser layer. In another example, the functional layer may be a prism to enhance brightness of the underlying film. Other functional or ornamental layers may be used such as a surface matte treatment and/or a scratch resistant treatment as desired for a given application of film.

The one or more barrier layers may be formed by, e.g., a low temperature wet process. As an example, the one or more barrier layers may comprise a flowable curable coating composition. As such, the flowable curable coating composition may be used to coat a surface, such as a quantum dot layer or a substrate. As an example, a low temperature wet process may include a coating method including but not limited to roll coating, gravure coating, knife coating, dip coating, curtain flow coating, spray coating, bar coating, die coating, spin coating, or inkjet coating and the like. Once cured, the one or more barrier layers may have a thickness that is less than the thickness of the barrier layer in some aspects.

FIG. 4A shows an example backlight structure in which the present film may be integrated. The backlight structure may be configured to emit electromagnetic radiation as part of an optical structure, such as an LCD panel. The backlight structure may comprise a reflector sheet, a mold frame, an LGP, and an LED reflector. The blacklight structure may comprise a quantum dot layer, a horizontal prism layer, a vertical prism layer, a protector sheet, and/or the like.

FIG. 4B shows an example optical device in which the present film may be integrated. The optical device may comprise the backlight structure of FIG. 4A. For example, the optical device may comprise one or more layers of an LCD panel disposed above the backlight structure. The optical device may comprise a bottom polarizer, a thin film transistor (TFT) glass, a color filter glass layer, a color filter layer, a top polarizer, and/or the like.

Methods of Making

Aspects of the disclosure further relate methods of making quantum dot films. In various aspects, a method of making a film may comprise forming a first polymer matrix comprising the plurality of first quantum dots disposed in the first polymer. The method may comprise forming a second polymer matrix comprising the plurality of second quantum dots disposed in the second polymer.

The method may comprise forming a combination of the first polymer matrix and the second polymer matrix. The combination may be a mixture. The combination (e.g., mixture) may be formed by a mechanical process. The first polymer matrix may be combined with the second polymer matrix such that at least a portion of the plurality of first quantum dots are caused to be dispersed with at least a portion of the plurality of second quantum dots. A dispersion of the plurality of first quantum dots and the plurality of second quantum dots relative to each other may be dependent on a miscibility of the first polymer relative to the second polymer. The first polymer may be partially miscible or immiscible relative to the second polymer.

The partial miscibility or the immiscibility of the first polymer relative to the second polymer may cause phase separation between portions of the plurality of first quantum dots and portions of the plurality of second quantum dots. The combination may comprise a plurality of phase separated regions. The plurality of phase separated regions may comprise first regions comprising portions of the first polymer and portions of the plurality of first quantum dots. The plurality of phase separated regions may comprise second regions comprising portions of the second polymer and portions of the plurality of second quantum dots. The plurality of phase separate regions may be separated based on the partial miscibility or immiscibility. The separation may occur during a drying (e.g., or curing) process. The combination of the first polymer matrix and the second polymer matrix may be disposed (e.g., coated) as a solution on a substrate. The solution may be dried (e.g., by heating, curing). Phase separation may occur as the solution dries. A chemical affinity between the first polymer and the plurality of first quantum dots may at least partially cause the phase separation. A chemical affinity between the second polymer and the plurality of second quantum dots may at least partially cause the phase separation.

Forming the first polymer matrix may comprise mixing (e.g., mechanically mixing) a first polymer resin of the first polymer with the plurality of first quantum dots. Forming the second polymer matrix may comprise mixing second polymer resin of the second polymer with the plurality of second quantum dots. Forming the quantum dot layer comprising the combination of the first polymer matrix and the second polymer matrix may comprise mixing the first polymer resin having the plurality of first quantum dots with the second polymer resin having the second plurality of quantum dots.

Forming the first polymer matrix and/or forming the second polymer matrix may comprise combining (e.g., mixing, dissolving) the first polymer and the second polymer in a solvent. The solvent may be configured to dissolve the first polymer and/or the second polymer. The plurality of first quantum dots and/or the plurality of first quantum dots may be dispersed in the solvent, resulting in a solution. The chemical affinities between the first polymer and the plurality of first quantum dots may cause the plurality of first quantum dots to combine with the first polymer (e.g., during a drying process). The chemical affinities between the second polymer and the plurality of second quantum dots may cause the plurality of second quantum dots to combine with the second polymer (e.g., during a drying process).

The method may comprise forming a quantum dot layer comprising the combination of the first polymer matrix and the second polymer matrix. In various aspects, the forming the quantum dot layer may comprise disposing (e.g., coating) the quantum dot layer on a barrier layer. For example, QDs may be disposed via a printing process (such as 3-D printing), a lithography process, or a polymerization process. However, other process may be used. A barrier or protective layer may be applied by means of roll coating, gravure coating, knife coating, dip coating, curtain flow coating, spray coating, bar coating, die coating, spin coating or inkjet coating, by using a dispenser, or other means.

The barrier or protective solution may be cured to form a protective layer adhered to the quantum dot layer. The protective solution may be cured using one or more of a radiation curing process including but not limited to an ultraviolet (UV) curing process and a thermal curing process including but not limited to a steam curing process. The protective layer inhibits the permeation of at least oxygen and moisture into the quantum dot layer.

A solution coating may be applied to the barrier film or protective layer, typically acrylic material with UV curing. In some examples, a polymer based barrier or protective film may be coated with an inorganic layer (e.g., aluminum oxide, $Al_2O_3$) via atomic deposition technology or physical vapor deposition, for example.

The method can include coating a surface of a substrate, such as a solid plastic form, with a flowable curable coating composition. The coating can be performed in any suitable manner that forms a coating of the flowable curable coating composition on a surface of the solid plastic form. Wet or transfer coating methods can be used. For example, the coating can be bar coating, spin coating, spray coating, or dipping. Single- or multiple-side coatings can be performed.

The substrate may be transparent, opaque, or any one or more colors. The solid plastic form can include any one or more suitable plastics (e.g., as a homogeneous mixture of plastics). In some aspects, the substrate may include at least one of an acrylonitrile butadiene styrene (ABS) polymer, an acrylic polymer, a celluloid polymer, a cellulose acetate polymer, a cycloolefin copolymer (COC), an ethylene-vinyl acetate (EVA) polymer, an ethylene vinyl alcohol (EVOH) polymer, a fluoroplastic, an ionomer, an acrylic/PVC alloy, a liquid crystal polymer (LCP), a polyacetal polymer (POM or acetal), a polyacrylate polymer, a polymethylmethacrylate polymer (PMMA), a polyacrylonitrile polymer (PAN or acrylonitrile), a polyamide polymer (PA or nylon), a polyamide-imide polymer (PAI), a polyaryletherketone polymer (PAEK), a polybutadiene polymer (PBD), a polybutylene polymer (PB), a polybutylene terephthalate polymer (PBT), a polycaprolactone polymer (PCL), a polychlorotrifluoroethylene polymer (PCTFE), a polytetrafluoroethylene polymer (PTFE), a polyethylene terephthalate polymer (PET), a polycyclohexylene dimethylene terephthalate polymer (PCT), a polycarbonate polymer (PC), a polyhydroxyalkanoate polymer (PHA), a polyketone polymer (PK), a polyester polymer, a polyethylene polymer (PE), a polyetheretherketone polymer (PEEK), a polyetherketoneketone polymer (PEKK), a polyetherketone polymer (PEK), a polyetherimide polymer (PEI), a polyethersulfone polymer (PES), a polyethylenechlorinate polymer (PEC), a polyimide polymer (PI), a polylactic acid polymer (PLA), a polymethylpentene polymer (PMP), a polyphenylene oxide polymer (PPO), a polyphenylene sulfide polymer (PPS), a polyphthalamide polymer (PPA), a polypropylene polymer, a polystyrene polymer (PS), a polysulfone polymer (PSU), a polytrimethylene terephthalate polymer (PTT), a polyurethane polymer (PU), a polyvinyl acetate polymer (PVA), a polyvinyl chloride polymer (PVC), a polyvinylidene chloride polymer (PVDC), a polyamideimide polymer (PAI), a polyarylate polymer, a polyoxymethylene polymer (POM), and a styrene-acrylonitrile polymer (SAN). In some embodiments, the solid plastic form includes at least one of polycarbonate polymer (PC), polymethylmethacrylate polymer (PMMA), or a blend thereof.

The substrate may include one or more polycarbonate or multiple types of polycarbonate. The polycarbonate can be made via interfacial polymerization (e.g., reaction of bisphenol with phosgene at an interface between an organic solution such as methylene chloride and a caustic aqueous solution) or melt polymerization (e.g., transesterification and/or polycondensation of monomers or oligomers above the melt temperature of the reaction mass). The substrate may include a filler, such as one filler or multiple fillers. The substrate may include a polyester.

The substrate may have any suitable shape and size. In some embodiments, the substrate is a sheet having any suitable thickness, such as a thickness of about 25 microns to about 50,000 microns, about 25 microns to about 15,000 microns, about 60 microns to about 800 microns, or about 25 microns or less, or about 50, 75, 100, 150, 200, 250, 300, 400, 500, 600, 700, 800, 900, 1,000, 1,500, 2,000, 3,000, 4,000, 5,000, 6,000, 8,000, 10,000, 12,000, 14,000, 15,000, 20,000, 25,000, 30,000, 40,000, or about 50,000 microns or more.

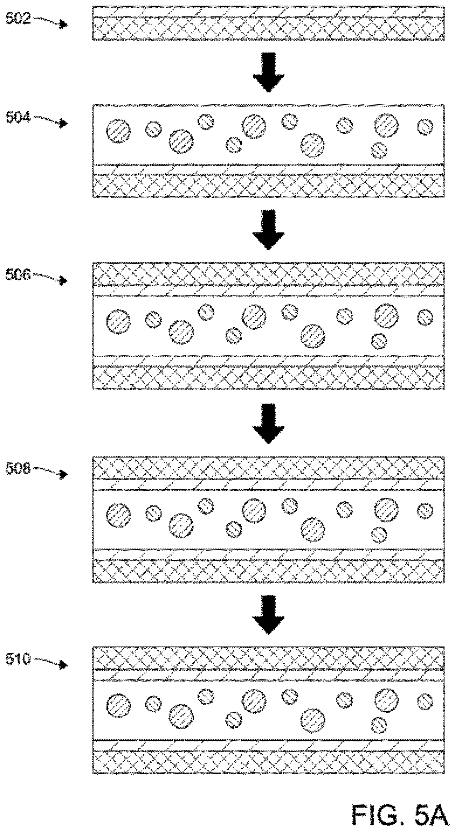

FIG. 5A shows an example process 500 for forming the disclosed film. The process 500 may comprise a thermal curing process. The process 500 may comprise coating in an N₂ atmosphere. At step 502, a barrier film may be formed on a substrate. At step 504, a quantum dot layer may be disposed above the barrier film. The barrier film may be coated with a solution comprising a combination of the first polymer, the second polymer, the plurality of first quantum dots, the plurality of second quantum dots, a compatibilizer, a combination thereof, and/or the like. At step 506, for example, a second barrier layer may be formed above the quantum dot layer. For example, a laminating process may be performed. At step 508, ultra violet (UV) curing may be performed. At step 510, thermal curing may be performed.

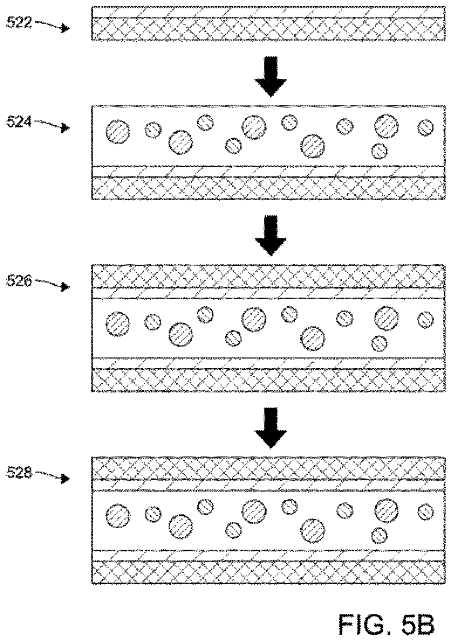

FIG. 5B shows another example process 520 for forming the disclosed film. The process 520 may comprise a UV curing process. The process 500 may comprise coating in air. At step 522, a barrier film may be formed on a substrate. At step 524, a quantum dot layer may be disposed above the barrier film. The barrier film may be coated with a solution comprising a combination of the first polymer, the second polymer, the plurality of first quantum dots, the plurality of second quantum dots, a compatibilizer, a combination thereof, and/or the like. At step 526, a laminating process may be performed. For example, a second barrier layer may be formed above the quantum dot layer. At step 528, ultra violet (UV) curing may be performed.

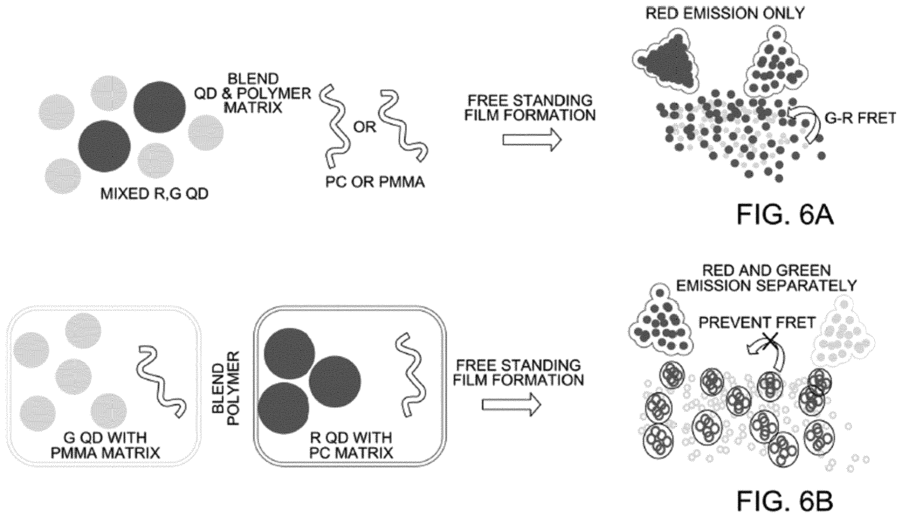

FIG. 6A is a diagram illustrating a process for forming a film. As shown on the left, red and green quantum dots may be mixed with a polymer matrix, such as PC or PMMA. The resulting film is shown on the right. Due to fluorescence resonance energy transfer (FRET), green light is absorbed by the red quantum dots, resulting in only emission of red light.

FIG. 6B is a diagram illustrating another process for forming a film based on the present disclosure. As shown on the left, green quantum dots are mixed with a PMMA based polymer matrix. Red quantum dots are mixed with a PC based polymer matrix. Both mixtures are combined and formed into a film. The resulting film emits green light and red light separately. The phase separation between the two different polymers reduces or prevents the absorption of green light related to FRET.

Examples

By way of illustration and as a non-limiting example, a quantum dot film was formed according to the following specifications. The quantum dot film was formed with a thickness of about 100 μm. The emission wavelength of the quantum dots was 525 nm (green) and 629 nm (red). The polymers for the quantum dot film included PMMA (e.g., for green quantum dots) and PC (e.g., for red quantum dots). To make a 15.4 x 9.85 cm² film, 51 mg of red QDs were mixed with 0.2 mL of Polycarbonate (PC) dissolved in chloroform. The concentration of PC solution was 10%. 91 mg of green QDs were mixed with 5 mL of Polymethylmethacrylate (PMMA) dissolved in chloroform. The concentration of PMMA solution was 10%. Testing of the example quantum dot film indicated that the ratio of materials used showed exact white color (0.33, 0.33).

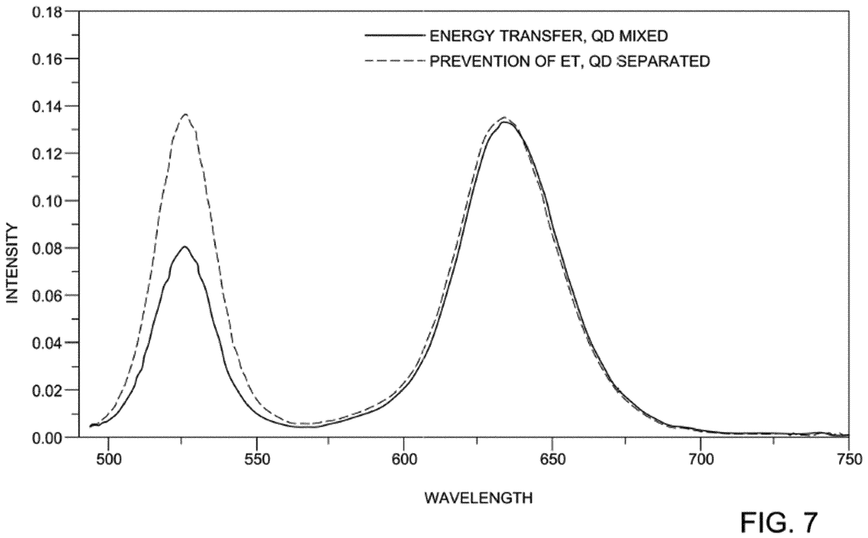

FIG. 7 shows that the example quantum dot film shows high green light intensity compared with mixed QD film. This result indicates that the reabsorption of green light from green QDs to red QDs is effectively prevented. Additionally, this formulation can be applied to the same QD film making process without any process modification. FIG. 7 illustrates intensity and wavelength for the example quantum dot film and control film illustrated in FIG. 6A and FIG. 6B. Two QD films were prepared following the composition as shown in Table 1.

**Table 1. Composition of QD films**

|  | Test (QD separated) | Control (QD mixed) |
|---|---|---|
| Green QDs amount | The same | The same |
| Red QDs amount | The same | The same |
| Matrix | PMMA for Green QDs, PC for Red QDs | PC or PMMA |
| Solvent | Chloroform | Chloroform |

In the control system, both green and red QDs were mixed together in the same polymer matrix and positioned randomly. In the test film (e.g., the example quantum dot film described above), green and red QDs were separately mixed with relative polymer resin which is partially miscible. Subsequently, the polymer resin comprising green QD were mixed with the polymer resins (e.g., PMMA and PC) comprising red QDs. Due to the limited miscibility between two different matrix polymers, green QDs and red QDs phase separated spontaneously. This phase separation between green QDs and red QDs reduced the energy transfer and loss as compared to the control film.

The present disclosure relates to at least the following aspects.

Aspect 1. A film comprising: a plurality of first quantum dots disposed in a first polymer, wherein the plurality of first quantum dots emit first secondary light upon excitation by light; and a plurality of second quantum dots disposed in a second polymer, wherein the plurality of second quantum dots emit second secondary light upon excitation by light, wherein the first polymer is combined with the second polymer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the miscibility of the first polymer relative to the second polymer is greater than 0% and less than 100%.

Aspect 2. The film of aspect 1, wherein the partial miscibility of the first polymer relative to the second polymer causes phase separation between portions of the plurality of first quantum dots and portions of the plurality of second quantum dots.

Aspect 3. The film of aspects 1-2, wherein the plurality of first quantum dots and the plurality of second quantum dots are disposed in a quantum dot layer adjacent to a light source, and wherein the light source comprises a blue light emitting source.

Aspect 4. The film of any one of aspects 1-3, wherein the plurality of first quantum dots comprise quantum dots sized from about 3 nanometers (nm) to about 11 nm.

Aspect 5. The film of any one of aspects 1-4, wherein the plurality of first quantum dots comprise red phosphor with a peak emission wavelength between about 600 nm to about 750 nm.

Aspect 6. The film of any one of aspects 1-5, wherein the plurality of second quantum dots comprise quantum dots sized from about 1 nm to about 8 nm.

Aspect 7. The film of any one of aspects 1-6, wherein the plurality of second quantum dots comprise green phosphor with a peak emission wavelength between about 490 nm to about 580 nm.

Aspect 8. The film of any one of aspects 1-7, further comprising: a quantum dot layer comprising the plurality of first quantum dots and the plurality of second quantum dots; and one or more barrier layers that enclose the quantum dot layer.

Aspect 9. The film of aspect 8, wherein one or both of the plurality of first quantum dots and the plurality of second quantum dots are disposed in the quantum dot layer by way of a coating process, a printing process, a lithography process, or a polymerization process.

Aspect 10. The film of any one of aspects 1-9, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 11. The film of any one of aspects 1-10, wherein one or both of the plurality of first quantum dots and the plurality of second quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

Aspect 12. The film of any one of aspects 1-10, wherein one or both of the plurality of first quantum dots and the plurality of second quantum dots comprise a core-shell structure.

Aspect 13. An article comprising the film of any one of aspects 1-12.

Aspect 14. A method comprising: forming a first polymer matrix comprising a plurality of first quantum dots disposed in a first polymer, wherein the plurality of first quantum dots emit first secondary light upon excitation by light; forming a second polymer matrix comprising a plurality of second quantum dots disposed in a second polymer, wherein the second polymer is partially miscible with the first polymer, wherein the plurality of second quantum dots emit second secondary light upon excitation by light; forming a combination of the first polymer matrix and the second polymer matrix, wherein the first polymer matrix is combined with the second polymer matrix such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the miscibility of the first polymer relative to the second polymer is greater than 0% and less than 100%; and forming a quantum dot layer comprising the combination of the first polymer matrix and the second polymer matrix.

Aspect 15. The method of aspect 14, wherein the partial miscibility of the first polymer relative to the second polymer causes phase separation between portions of the plurality of first quantum dots and portions of the plurality of second quantum dots.

Aspect 16. The method of any one of aspects 14-15, wherein forming the first polymer matrix comprises mixing first polymer resin of the first polymer with a plurality of first quantum dots, and wherein forming the second polymer matrix comprises mixing second polymer resin of the second polymer with a plurality of second quantum dots.

Aspect 17. The method of aspect 16, wherein forming the quantum dot layer comprising the combination of the first polymer matrix and the second polymer matrix comprises mixing the first polymer resin having the plurality of first quantum dots with the second polymer resin having the second plurality of quantum dots.

Aspect 18. The method of any one of aspects 14-17, wherein forming the quantum dot layer comprising the combination of the first polymer matrix and the second polymer matrix comprises forming the quantum dot layer adjacent to a light source, and wherein the light source comprises a blue light emitting source.

Aspect 19. The method of any one of aspects 14-18, wherein the plurality of first quantum dots comprise quantum dots sized from about 3 nanometers (nm) to about 11 nm.

Aspect 20. The method of any one of aspects 14-19, wherein the plurality of first quantum dots comprise red phosphor with a peak emission wavelength between about 600 nm to about 750 nm.

Aspect 21. The method of any one of aspects 14-20, wherein the plurality of second quantum dots comprise quantum dots sized from about 1 nm to about 8 nm.

Aspect 22. The method of any one of aspects 14-21, wherein the plurality of second quantum dots comprise green phosphor with a peak emission wavelength between about 490 nm to about 580 nm.

Aspect 23. The method of any one of aspects 14-22, wherein one or both of the plurality of first quantum dots and the plurality of second quantum dots are disposed in the quantum dot layer by way of a coating process, a printing process, a lithography process, or a polymerization process.

Aspect 24. The method of any one of aspects 14-23, further comprising forming one or more barrier layers that enclose the quantum dot layer.

Aspect 25. The method of any one of aspects 14-24, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 26. The method of any one of aspects 14-25, wherein one or both of the plurality of first quantum dots and the plurality of second quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

Aspect 27. The method of any one of aspects 14-26, wherein one or both of the plurality of first quantum dots and the plurality of second quantum dots comprise a core-shell structure.

Aspect 28. The method of any one of aspects 14-27, wherein forming the combination of the first polymer matrix and the second polymer matrix comprise mixing the first polymer matrix and the second polymer matrix such that the plurality first quantum dots are spontaneously phase separated from the plurality of second quantum dots.

Aspect 29. The method of any one of aspects 14-28, wherein the combination comprises a mixture.

Aspect 30. The method of any one of aspects 14-28, wherein the combination comprises a blend.

Aspect 31. A device comprising: a light source; and a quantum dot layer comprising: a plurality of first quantum dots disposed in a first polymer, wherein the plurality of first quantum dots emit first secondary light upon excitation by light, and a plurality of second quantum dots disposed in a second polymer, wherein the plurality of second quantum dots emit second secondary light upon excitation by light, and wherein the first polymer is combined with the second polymer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the miscibility of the first polymer relative to the second polymer is greater than 0% and less than 100%.

Aspect 32. A device comprising: a light source; and a quantum dot layer comprising: a plurality of first quantum dots disposed in a first polymer, wherein the plurality of first quantum dots emit first secondary light upon excitation by light, and a plurality of second quantum dots disposed in a second polymer, wherein the plurality of second quantum dots emit second secondary light upon excitation by light, and wherein the first polymer is combined with the second polymer and a compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer and the compatibilizer, wherein the first polymer is immiscible relative to the second polymer without the compatibilizer.

Aspect 33. A film comprising: a plurality of first quantum dots disposed in a first polymer, wherein the plurality of first quantum dots emit first secondary light upon excitation by light; and a plurality of second quantum dots disposed in a second polymer, wherein the plurality of second quantum dots emit second secondary light upon excitation by light, wherein the first polymer is combined with the second polymer and a compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a partial miscibility of the first polymer relative to the second polymer and the compatibilizer, wherein the first polymer is immiscible relative to the second polymer without the compatibilizer.

Aspect 34. The film of aspect 33, wherein the partial miscibility of the first polymer relative to the second polymer and the compatibilizer causes phase separation between portions of the plurality of first quantum dots and portions of the plurality of second quantum dots.

Aspect 35. The film of any one of aspects 33-34, wherein the plurality of first quantum dots and the plurality of second quantum dots are disposed in a quantum dot layer adjacent to a light source, and wherein the light source comprises a blue light emitting source.

Aspect 36. The film of any one of aspects 33-35, wherein the plurality of first quantum dots comprise quantum dots sized from about 3 nanometers (nm) to about 11 nm.

Aspect 37. The film of any one of aspects 33-36, wherein the plurality of second quantum dots comprise quantum dots sized from about 1 nm to about 8 nm.

Aspect 38. The film of any one of claims 33-37, further comprising: a quantum dot layer comprising the plurality of first quantum dots and the plurality of second quantum dots; and one or more barrier layers that enclose the quantum dot layer.

Aspect 39. The film of aspect 38, wherein one or both of the plurality of first quantum dots and the plurality of second quantum dots are disposed in the quantum dot layer by way of a coating process, a printing process, a lithography process, or a polymerization process.

Aspect 40. The film of any one of aspects 33-39, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 41. The film of any one of aspects 33-40, wherein one or both of the plurality of first quantum dots and the plurality of second quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

Aspect 42. The film of any one of aspects 33-41, wherein the compatibilizer comprises a block copolymer comprising the first polymer and the second polymer.

Aspect 43. A method comprising: forming a first polymer matrix comprising a plurality of first quantum dots disposed in a first polymer, wherein the plurality of first quantum dots emit first secondary light upon excitation by light; forming a second polymer matrix comprising a plurality of second quantum dots disposed in a second polymer, wherein the second polymer is partially miscible with the first polymer, wherein the plurality of second quantum dots emit second secondary light upon excitation by light; forming a combination of the first polymer matrix and the second polymer matrix and a compatibilizer, wherein the first polymer matrix is combined with the second polymer matrix and the compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a miscibility of the first polymer relative to the second polymer, wherein the first polymer is immiscible relative to the second polymer without the compatibilizer (e.g., the miscibility of the first polymer relative to the second polymer and the compatibilizer is greater than 0% and less than 100%); and forming a quantum dot layer comprising the combination of the first polymer matrix, the second polymer matrix, and the compatibilizer.

Aspect 44. The method of aspect 43, wherein the partial miscibility of the first polymer relative to the second polymer and the compatibilizer causes phase separation between portions of the plurality of first quantum dots and portions of the plurality of second quantum dots.

Aspect 45. The method of any one of aspects 43-44, wherein forming the first polymer matrix comprises mixing first polymer resin of the first polymer with a plurality of first quantum dots, and wherein forming the second polymer matrix comprises mixing second polymer resin of the second polymer with a plurality of second quantum dots.

Aspect 46. The method of aspect 45, wherein forming the quantum dot layer comprising the combination of the first polymer matrix, the second polymer matrix and the compatibilizer comprises mixing the first polymer resin having the plurality of first quantum dots with the compatibilizer and the second polymer resin having the second plurality of quantum dots.

Aspect 47. The method of any one of aspects 43-46, wherein forming the quantum dot layer comprising the combination of the first polymer matrix, the second polymer matrix, and the compatibilizer comprises forming the quantum dot layer adjacent to a light source, and wherein the light source comprises a blue light emitting source.

Aspect 48. The method of any one of aspects 43-47, wherein the plurality of first quantum dots comprise quantum dots sized from about 3 nanometers (nm) to about 11 nm.

Aspect 49. The method of any one of aspects 43-48, wherein the plurality of first quantum dots comprise red phosphor with a peak emission wavelength between about 600 nm to about 750 nm.

Aspect 50. The method of any one of aspects 43-49, wherein the plurality of second quantum dots comprise quantum dots sized from about 1 nm to about 8 nm.

Aspect 51. The method of any one of aspects 43-50, wherein the plurality of second quantum dots comprise green phosphor with a peak emission wavelength between about 490 nm to about 580 nm.

Aspect 52. The method of any one of aspects 43-51, wherein one or both of the plurality of first quantum dots and the plurality of second quantum dots are disposed in the quantum dot layer by way of a coating process, a printing process, a lithography process, or a polymerization process.

Aspect 53. The method of any one of aspects 43-52, further comprising forming one or more barrier layers that enclose the quantum dot layer.

Aspect 54. The method of any one of aspects 43-53, wherein the first polymer or the second polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 55. The method of any one of aspects 43-54, wherein one or both of the plurality of first quantum dots and the plurality of second quantum dots comprise CdS, CdSe, CdTe, ZnS, ZnSe, ZnTe, ZnO, HgS, HgSe, HgTe, GaN, GaP, GaAs, GaSb, AlN, AlP, AlAs, AlSb, InN, InP, InAs, InSb, SnS, SnSe, SnTe, PbS, PbSe, PbTe, SiC, SiGe, GaAs, GaP, GaAs, GaSb, HgS, HgSe, HgTe, InAs, InP, InSb, AlAs, alloys thereof, or mixtures thereof.

Aspect 56. The method of any one of aspects 43-55, wherein one or both of the plurality of first quantum dots and the plurality of second quantum dots comprise a core-shell structure.

Aspect 57. The method of any one of aspects 43-56, wherein forming the combination of the first polymer matrix, the second polymer matrix, and the compatibilizer comprises mixing the first polymer matrix, the second polymer matrix, and the compatibilizer such that the plurality first quantum dots are spontaneously phase separated from the plurality of second quantum dots.

Aspect 58. The method of any one of aspects 43-57, wherein the combination comprises a mixture.

Aspect 59. The method of any one of aspects 43-57, wherein the combination comprises a blend.

Aspect 60. The method of any one of aspects 43-59, wherein the compatibilizer comprises a block copolymer comprising the first polymer and the second polymer.

Aspect 61. A device comprising a light source and a film of any one of aspects 1-12.

Aspect 62. A device comprising a light source and a film of any one of aspects 33-42.

## Definitions

It is to be understood that the terminology used herein is for the purpose of describing particular aspects only and is not intended to be limiting. As used in the specification and in the claims, the term "comprising" can include the embodiments "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading may occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

As used herein, "quantum dots" or "QDs" (or QD, singular) refers to semiconductor nanometer structures that confine conduction band electrons, valence band holes and excitons in three spatial directions. This confinement can be attributed to the factors: electrostatic potential (generated by external electrodes, doping, stress or impurity), interface between two different semiconductor materials (for example in self-assembling quantum dots), semiconductor surface (such as semiconductor nanocrystal) or a combination of the above. QD's have a discrete quantized energy spectrum, and the corresponding wave function is located in the quantum dot in space, but extends across several crystal lattice periods. One quantum dot has a small amount of electrons (e.g., from about 1 to about 100), holes or hole-electron pairs, that is, the quantity of electricity it carries is an integral multiple of element of electric-charges. A quantum dot is a nanoparticle comprised of II-VI group or III-V group elements. The particle diameter of a quantum dot is generally between 1 nm and 10 nm. Since electrons and holes are quantumly confined, the continuous energy band structure is transformed into a discrete energy level structure with molecular characteristics, which can emit fluorescence after being stimulated.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation.

The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which may be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "transparent" means that the level of transmittance for a disclosed composition is greater than 50%. It is preferred that the transmittance be at least 60%, 70%, 80%, 85%, 90%, or 95%, or any range of transmittance values derived from the above exemplified values. In the definition of "transparent", the term "transmittance" refers to the amount of incident light that passes through a sample measured in accordance with ASTM D1003 at a thickness of 3.2 millimeters.

As used herein, the term "refractive index" The terms "refractive index" or "index of refraction" as used herein refer to a dimensionless number that is a measure of the speed of light in that substance or medium. It is typically expressed as a ratio of the speed of light in vacuum relative to that in the considered substance or medium. This can be written mathematically as:

$$n = \text{speed of light in a vacuum} \, / \, \text{speed of light in medium.}$$

As used herein, the term "polymer" refers to a molecule having at least one repeating unit and can include copolymers and homopolymers. The polymers described herein can terminate in any suitable way. In some embodiments, the polymers can terminate with an end group that is independently chosen from a suitable polymerization initiator, -H, -OH, a substituted or unsubstituted $(C_1-C_{20})$hydrocarbyl (e.g., $(C_1-C_{10})$alkyl or $(C_6-C_{20})$aryl) interrupted with 0, 1, 2, or 3 groups independently selected from -O-, substituted or unsubstituted -NH-, and -S-, a poly(substituted or unsubstituted $(C_1-C_{20})$hydrocarbyloxy), and a poly(substituted or unsubstituted $(C_1-C_{20})$hydrocarbylamino).

Illustrative types of polyethylene include, for example, ultra-high molecular weight polyethylene (UHMWPE, for example, a molar mass between 3.5 and 7.5 million atomic mass units), ultra-low molecular weight polyethylene (ULMWPE), high molecular weight polyethylene (HMWPE), high density polyethylene (HDPE, for example, a density of about 0.93 to 0.97 grams per cubic centimeter $(g/cm^3)$ or 970 kilograms per cubic meter $(kg/m^3)$), high density cross-linked polyethylene (HDXLPE, for example, a density of about 0.938 to about 0.946 $g/cm^3$), cross-linked polyethylene (PEX or XLPE, for example, a degree of cross-linking of between 65 and 89% according to ASTM F876), medium density polyethylene (MDPE, for example, a density of 0.926 to 0.940 $g/cm^3$), low density polyethylene (LDPE, for example, about 0.910 $g/cm^3$ to 0.940 $g/cm^3$), linear low density polyethylene (LLDPE) and very low density polyethylene (VLDPE, for example, a density of about 0.880 to 0.915 $g/cm^3$).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A film comprising:

    a plurality of first quantum dots disposed in a first polymer, wherein the plurality of first quantum dots emit first secondary light upon excitation by light; and
    a plurality of second quantum dots disposed in a second polymer, wherein the plurality of second quantum dots emit second secondary light upon excitation by light,
    wherein the first polymer is combined with the second polymer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a partial miscibility of the first polymer relative to the second polymer, wherein the partial miscibility of the first polymer relative to the second polymer is greater than 0% miscibility and less than 100% miscibility.

2. The film of claim 1, wherein the partial miscibility of the first polymer relative to the second polymer causes phase separation between portions of the plurality of first quantum dots and portions of the plurality of second quantum dots.

3. The film of any one of claims 1-2, wherein the plurality of first quantum dots and the plurality of second quantum dots are disposed in a quantum dot layer adjacent to a light source, and wherein the light source comprises a blue light emitting source.

4. The film of any one of claims 1-3, wherein the plurality of first quantum dots comprise quantum dots sized from about 3 nanometers (nm) to about 11 nm.

5. The film of any one of claims 1-4, wherein the plurality of second quantum dots comprise quantum dots sized from about 1 nm to about 8 nm.

6. The film of any one of claims 1-5, further comprising:

    a quantum dot layer comprising the plurality of first quantum dots and the plurality of second quantum dots; and
    one or more barrier layers that enclose the quantum dot layer.

7. The film of claim 6, wherein one or both of the plurality of first quantum dots and the plurality of second quantum dots are disposed in the quantum dot layer by way of a coating process, a printing process, a lithography process, or a polymerization process.

**8.** A film comprising:

a plurality of first quantum dots disposed in a first polymer, wherein the plurality of first quantum dots emit first secondary light upon excitation by light; and

a plurality of second quantum dots disposed in a second polymer, wherein the plurality of second quantum dots emit second secondary light upon excitation by light,

wherein the first polymer is combined with the second polymer and a compatibilizer such that at least a portion of the plurality of first quantum dots are caused to be dispersed with at least a portion of the plurality of second quantum dots, and wherein a dispersion of the plurality of first quantum dots and the plurality of second quantum dots relative to each other is dependent on a partial miscibility of the first polymer relative to the second polymer and the compatibilizer, wherein the first polymer is immiscible relative to the second polymer without the compatibilizer.

**9.** The film of claim 8, wherein the partial miscibility of the first polymer relative to the second polymer and the compatibilizer causes phase separation between portions of the plurality of first quantum dots and portions of the plurality of second quantum dots.

**10.** The film of any one of claims 8-9, wherein the plurality of first quantum dots and the plurality of second quantum dots are disposed in a quantum dot layer adjacent to a light source, and wherein the light source comprises a blue light emitting source.

**11.** The film of any one of claims 8-10, wherein the plurality of first quantum dots comprise quantum dots sized from about 3 nanometers (nm) to about 11 nm.

**12.** The film of any one of claims 8-11, wherein the plurality of second quantum dots comprise quantum dots sized from about 1 nm to about 8 nm.

**13.** The film of any one of claims 8-12, further comprising:

a quantum dot layer comprising the plurality of first quantum dots and the plurality of second quantum dots; and

one or more barrier layers that enclose the quantum dot layer.

**14.** The film of any one of claims 8-13, wherein the compatibilizer comprises a block copolymer comprising the first polymer and the second polymer.

**15.** A device comprising:

a light source; and

a film of any one of claims 1-14.

FIG. 1A

FIG. 1B

FIG. 2

FIG. 3A

FIG. 3B

PROTECTOR SHEET ➡

PRISM SHEET(H) ➡

PRISM SHEET(V) ➡

QD FILM ➡

LGP
REFLECTOR SHEET
MOLD FRAME

LED ➡

LED REFLECTOR

**FIG. 4A**

Polarizer

Color Filter

Color Filter Glass

Liquid Crystal
Voltage

TFT Glass

Polarizer

Backlight

**FIG. 4B**

502 —→

504 —→

506 —→

508 —→

510 —→

FIG. 5A

522 →

524 →

526 →

528 →

FIG. 5B

FIG. 6A

FIG. 6B

FIG. 7

EP 3 530 712 A1

Pure
Components

T$_{g1}$     T$_{g2}$

Temperature

FIG. 8A

Miscible
Blend

T$_{g12}$

Temperature

FIG. 8B

Immiscible
Blend

T$_{g1}$     T$_{g2}$

Temperature

FIG. 8C

Europäisches
Patentamt

European
Patent Office

Office européen
des brevets

# EUROPEAN SEARCH REPORT

Application Number

EP 18 15 8199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE WPI<br>Week 201434<br>1 February 2014 (2014-02-01)<br>Thomson Scientific, London, GB;<br>AN 2014-H83005<br>XP002784267,<br>-& TW 201 404 805 A (CHIMEI INNOLUX CORP)<br>1 February 2014 (2014-02-01)<br>* abstract *<br>* Machine translation;<br>paragraphs [0002], [0003], [0015] -<br>[0023]; claim 14 * | 1-15 | INV.<br>C09K11/02<br>H05B33/14 |
| X | WO 2016/189827 A1 (FUJIFILM CORP [JP])<br>1 December 2016 (2016-12-01)<br>* Machine translation;<br>paragraphs [0002], [0005] - [0012],<br>[0039] - [0050], [0143] - [0154]; claims;<br>figures 1,4; table 6 * | 1-15 | |
| A | MOURA I ET AL: "Morphology, optical, and electric properties of polymer-quantum dots nanocomposites: effect of polymeric matrix",<br>JOURNAL OF MATERIALS SCIENCE, KLUWER ACADEMIC PUBLISHERS, DORDRECHT,<br>vol. 51, no. 18, 20 June 2016 (2016-06-20)<br>, pages 8699-8710, XP035992328,<br>ISSN: 0022-2461, DOI:<br>10.1007/S10853-016-0129-8<br>[retrieved on 2016-06-20]<br>* the whole document * | 1-15 | TECHNICAL FIELDS SEARCHED (IPC)<br><br>C09K<br>H05B<br>H01L |

-/--

The present search report has been drawn up for all claims

| Place of search | Date of completion of the search | Examiner |
|---|---|---|
| The Hague | 29 August 2018 | Baldé, Kaisa |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**EUROPEAN SEARCH REPORT**

Europäisches Patentamt
European Patent Office
Office européen des brevets

Application Number

EP 18 15 8199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YUNYONG GUO ET AL: ""Smart" Self-Assembled Quantum Dots Regulate and Stabilize Structure in Phase-Separated Polymer Blends", CHEMISTRY OF MATERIALS, vol. 19, no. 26, 1 December 2007 (2007-12-01), pages 6581-6587, XP055502974, ISSN: 0897-4756, DOI: 10.1021/cm7024119 * Introduction, Conclusions, Scheme 1; figure 4 * | 1-15 | |
| A | WO 2013/114254 A2 (KONINKL PHILIPS NV [NL]) 8 August 2013 (2013-08-08) * page 2, last paragraph - page 3, last paragraph * * page 7, paragraph 1 - page 8, paragraph 1; figures * | 1-15 | |

TECHNICAL FIELDS SEARCHED (IPC)

The present search report has been drawn up for all claims

| Place of search | Date of completion of the search | Examiner |
|---|---|---|
| The Hague | 29 August 2018 | Baldé, Kaisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 8199

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2018

| Patent document cited in search report | | Publication date | Patent family member(s) | | | Publication date |
|---|---|---|---|---|---|---|
| TW 201404805 | A | 01-02-2014 | NONE | | | |
| WO 2016189827 | A1 | 01-12-2016 | JP | WO2016189827 | A1 | 21-12-2017 |
| | | | US | 2018081236 | A1 | 22-03-2018 |
| | | | WO | 2016189827 | A1 | 01-12-2016 |
| WO 2013114254 | A2 | 08-08-2013 | CN | 104105739 | A | 15-10-2014 |
| | | | EP | 2809710 | A2 | 10-12-2014 |
| | | | ES | 2627005 | T3 | 26-07-2017 |
| | | | JP | 6118825 | B2 | 19-04-2017 |
| | | | JP | 2015516467 | A | 11-06-2015 |
| | | | KR | 20140126363 | A | 30-10-2014 |
| | | | RU | 2014135769 | A | 27-03-2016 |
| | | | US | 2014369024 | A1 | 18-12-2014 |
| | | | WO | 2013114254 | A2 | 08-08-2013 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015022526 A1

**Non-patent literature cited in the description**

- **WARGNIER.** *Energy transfer in aqueous solutions of oppositely charged CdSe/ZnS core/shell quantum dots and in quantum dot-nanogold assemblies,* 2004
- **AARON.** *Forster Resonance Energy Transfer Investigations Using Quantum-Dot Fluorophores,* 2006
- **YIN.** *Efficient Heterotransfer between Visible Quantum Dots,* 2017
- **1990 ; KIM.** *Phase Behavior of Blends of Polycarbonate with Partially Miscible Polymers*